# EUROPEAN PATENT SPECIFICATION

(11) **EP 4 102 713 B1**
(45) Date of publication and mention of the grant of the patent: **20.05.2026**
(21) Application number: 21178430.1
(22) Date of filing: 09.06.2021
(51) Int. Cl.: H02M 7/00, H02K 11/33

(54) **INVERTER AND A MOTOR COMPRISING THE INVERTER**
WECHSELRICHTER UND MOTOR MIT DEM WECHSELRICHTER
ONDULEUR ET MOTEUR COMPRENANT L'ONDULEUR

(43) Date of publication of application: 14.12.2022
(73) Proprietor: MAHLE International GmbH, 70376 Stuttgart (DE)
(72) Inventor: AHEC, Ziga, 1290 Grosuplje (SI); BABIC, Gregor, 1312 Videm-Dobrepolje (SI); VERDEV, Luka, 3320 Velenje (SI)
(74) Representative: BRP Renaud & Partner mbB Rechtsanwälte Patentanwälte Steuerberater

(56) References cited:
- DE-C1- 19 756 186
- JP-A- 2019 057 968
- US-A1- 2020 352 041

## Description

The invention relates to an inverter for an electric motor. The invention also relates to the electric motor comprising the inverter.

A generic inverter for an electric motor usually has a capacitor board comprising capacitors and usually has a transistor board. The capacitor board and the transistor board are thereby interconnected to form a power circuit. In addition, the inverter has contacting units, which are electrically interconnected with the transistor board of the inverter. If the inverter is arranged on the electric motor, the contacting unit is connected to a phase terminal of the motor in an electrically conductive manner.

The phase terminal of the motor and the contact unit are thereby usually secured to one another in a force-fitted and detachable manner. It is problematic thereby to create an electrically conductive and secure contact point between the inverter and the electric motor. For example, the cross section of the contact point can be too small, so that the contact point can heat up during operation of the inverter, and the electrical conductivity of the contact point can be decreased. The contact points are therefore designed for high voltages and for large numbers of contacts, and are therefore massive and expensive.

JP 2019057968 A discloses an inverter with a capacitor board and a transistor board, which are accommodated in a housing. US 2020/0352041 A discloses a transistor module with a transistor board. The transistor board is spring-connected to external contacts via a contacting unit.

It is thus the object of the invention to specify an improved or at least alternative embodiment for an inverter for an electric motor and for the electric motor of the generic type, in the case of which the described disadvantages are overcome.

According to the invention, this object is solved by means of the subject matter of the independent claims. Advantageous embodiments are subject matter of the dependent claims.

An inverter is provided for an electric motor. The inverter thereby has a capacitor board comprising at least one capacitor and at least one transistor board. The capacitor board and the at least one transistor board are thereby aligned transversely to a longitudinal direction of the inverter and are electrically interconnected. In addition, the inverter has at least one electrically conductive contacting unit for contacting at least one electrically conductive phase terminal of the motor. The at least one contacting unit is thereby connected to the at least one transistor board in an electrically conductive manner. According to the invention, the respective contacting unit is resiliently formed in a longitudinal direction. In other words, the contacting unit is resilient in response to an axial contact force in the longitudinal direction.

In connection with the present invention, the terms "radially" and "axially" always refer to the longitudinal direction of the inverter. The terms "in the longitudinal direction" and "axially" as well as the terms "transversely to the longitudinal direction" and "radially" are further used synonymously for each other.

Advantageously, the contacting unit and thus also the inverter according to the invention are constructed in a simplified manner. The production costs of the inverter can thus be reduced. In addition, the resilient contacting unit can provide for a permanent electrically conductive contact between the inverter and the motor. The electrically conductive contact remains stable against vibrations, temperature changes, and sparking effects thereby.

Advantageously, the inverter can contain several transistor boards and several contacting units. According to the intended purpose, the number of the contacting units can advantageously correspond to the number of the transistor boards. According to the intended purpose, the number of the transistor boards can advantageously correspond to the number of the phase terminals of the electric motor. Advantageously, the number of the phase terminals can generally be a function of the design of the motor. Advantageously, the motor can have exactly three or exactly six phase terminals. Advantageously, the inverter can have exactly three or exactly six contacting units. Advantageously, the inverter can have exactly three or exactly six transistor boards. Advantageously, the inverter can have a single transistor board.

Advantageously, the transistor board can be arranged so as to surround the capacitor board or so as to surround the capacitor board in a circumferential direction. The circumferential direction surrounds the longitudinal direction. Advantageously, the respective transistor board and the capacitor board can be material bonded to one another, preferably welded, and can thus be contacted in an electrically conductive manner. Advantageously, the respective transistor board and the capacitor board can be connected to one another on one side. Preferably, the at least one transistor board and the capacitor board can be connected in such a way that a slightly axially movement of the respective transistor board on the capacitor board is possible. This enables the transistor board to be axially pressed against a cooling plate.

Advantageously, it can be provided that the inverter has an electrically insulating ring-shaped carrier, preferably made of plastic. The capacitor board can be then arranged on the carrier together with the at least one transistor board, which is firmly connected to the capacitor board, and the capacitor board can be firmly connected, preferably screwed, to the carrier.

Advantageously, the inverter can have further components, which are firmly connected, preferably screwed, to the carrier. For instance, the inverter can have a control board, which is firmly connected, preferably screwed, to the carrier.

Advantageously, the inverter can contain at least one positioning unit for the at least one transistor plate. The at least one positioning unit can contain at least one positioning projection and at least one positioning opening, which axially engage in each other. The positioning projection can be formed on the carrier and the at least one positioning opening can be formed in the at least one transistor board and/or in at least one contact plate which is arranged on the at least one transistor board and/or in at least one spring element which is arranged on the at least one transistor board.

In the case of an advantageous design of the inverter, it can be provided that the inverter has a cooling element, which is aligned transversely to the longitudinal direction at least in some regions. In response to the axial pressing force, the respective contacting unit then presses the respective transistor board against the cooling element so as to transfer heat. Advantageously, the cooling element can have cooling ducts, through which a cooling liquid can flow. Advantageously, the cooling element can be pot-shaped and can have a bottom, which is aligned transversely to the longitudinal direction. The at least one transistor board can then be axially pressed against the bottom of the cooling element. In the alternative, the cooling element can be formed by means of a cooling plate, which is aligned transversely to the longitudinal direction. The at least one transistor board can then be axially pressed against the cooling plate.

Advantageously, the respective transistor board can be arranged axially adjacent to the cooling element. Advantageously, the respective contacting unit can be arranged at the respective transistor board so as to face away from the cooling element. Advantageously, the at least one transistor board can be arranged so as to surround the capacitor board or so as to surround the capacitor board in a circumferential direction. The circumferential direction surrounds thereby the longitudinal direction. Advantageously, the capacitor board can be arranged adjacent to the cooling element. Advantageously, the capacitor can be arranged on the capacitor board facing the cooling element.

According to the invention, the respective contacting unit has a plate-like electrically conductive contact plate, which is aligned transversely to the longitudinal direction, and a resilient spring element. The respective spring element is thereby arranged axially between the respective contact plate and the respective transistor board, and resiliently connects the respective transistor board and the contact plate to one another. In response to the axial pressing force on the respective contact plate, the respective transistor board can thereby be pressed via the spring element against the above-described cooling element so as to transfer heat. Advantageously, the respective transistor board can be arranged axially adjacent to the cooling element. Advantageously, the respective contact plate and the respective spring element can be arranged at the respective transistor board so as to face away from the cooling element. The spring element can advantageously be formed of steel.

Advantageously, it can be provided that the respective spring element is material bonded, preferably welded, to the respective contact plate. Advantageously, the respective contact plate can be connected in an electrically conductive manner and material bonded, preferably welded, to the respective transistor board. Advantageously, the at least one transistor board and the capacitor board can be material bonded to one another, preferably welded, at a contact point. Advantageously, the transistor board can be arranged so as to surround the capacitor board or so as to surround the capacitor board in a circumferential direction. The circumferential direction surrounds there the longitudinal direction. Advantageously, the respective transistor board and the respective contact plate can be connected to one another on one side so as to allow relative movement between the transistor board and the respective contact plate. Advantageously, the respective transistor board can be connected to the capacitor board and to the contact plate at two sides located opposite one another.

Advantageously, the spring element can have a plate-like plate element, which is aligned transversely to the longitudinal direction, and at least two feet, which integrally connect radially to the plate element. In addition, the respective spring element can rest with the plate element against the respective contact plate and resiliently with the feet against the respectively transistor board. The respective spring element can thus connect the respective contact plate and the respective transistor board to one another in an axially resilient manner.

Advantageously, it can be provided that the respective contact plate has a central contact opening for inserting and for contacting the respective phase terminal of the motor. At least two contact pins, which are directed towards the center of the contact opening and axially to the spring element, can thereby be formed at the contact opening. The contact pins can thus form a conical cone structure in the contact opening for receiving the respective phase terminal of the electric motor. Due to the cone structure, in particular the axial pressing force, which is generated by the phase terminal, can be increased axially in the direction of the respective transistor board.

Advantageously, it can be provided that a groove structure is in each case formed at a contact surface of the respective contact pin facing the phase terminal. The groove structure can be, for example, wave-shaped. The electrically conductive contact point between the respective phase terminal of the electric motor and the conventional contacting unit of the inverter is generally formed by means of individual contact points. In comparison, several contact lines are created by means of the groove structure between the respective phase terminal and the respective contact plate. The contacting of the respective phase terminal of the electric motor and the respective contact plate can thus be improved significantly.

The invention also relates to an electric motor comprising the above-described inverter. The motor thereby has at least one electrically conductive phase terminal, which extends axially towards the inverter at least in some regions. The inverter is thereby axially attached, thus in the longitudinal direction, to the motor with a longitudinal end, which faces the motor. The at least one contacting unit of the inverter is contacted in an electrically conductive manner with the at least one phase terminal of the motor.

Advantageously, the inverter can be axially attached to the motor in such a way that an axis of rotation of the motor or of a rotor of the motor, respectively, is aligned parallel to the longitudinal direction of the inverter. Advantageously, the inverter can be axially attached to the motor in such a way that a longitudinal central axis of the motor is aligned parallel to the longitudinal direction of the inverter. Advantageously, the inverter can be axially attached to the motor in such a way that a longitudinal central axis of the motor coincides with a longitudinal central axis, which is aligned parallel to the longitudinal direction of the inverter.

Advantageously, the inverter and the motor can be firmly connected, preferably screwed, to one another. Advantageously, the at least one phase terminal can be formed in the form of a connecting piece, which is cylindrical and which is aligned axially to the inverter, at least in some regions. Advantageously, the contacting unit of the inverter can be designed as described above and can have a contact plate and an axially resilient spring element. Advantageously, the respective phase terminal of the motor can then be contacted in an electrically conductive manner with the respective contact plate of the contacting unit of the inverter.

Advantageously, it can be provided that the respective phase terminal of the motor generate an axial pressing force on the respective contacting unit of the inverter. The respective contacting unit can thereby press the respective transistor board against a cooling element of the inverter so as to transfer heat by means of the axial pressing force of the phase terminal of the motor. Advantageously, the respective contacting unit of the inverter can be designed as described above, and can have a contact plate and an axially resilient spring element. Advantageously, the respective contact plate can then axially press the respective transistor board via the respective resilient spring element against the cooling element and so as to transfer heat by means of the axial pressing force of the phase terminal.

Advantageously, it can be provided that the motor is a six-phase motor comprising exactly six phase terminals, and the six phase terminals are arranged so as to be distributed around the axis of rotation of the motor or of a rotor of the motor, respectively. The inverter then has exactly six transistor boards for the exactly six phase terminals of the motor, and the transistor boards are arranged so as to be distributed around the at least one capacitor of the capacitor board around the longitudinal direction of the inverter.

Further important features and advantages of the invention follow from the subclaims, from the drawings, and from the corresponding figure description on the basis of the drawings.

It goes without saying that the above-mentioned features and the features, which will be described below, cannot only be used in the respective specified combination, but also in other combinations or alone, without leaving the scope of the present invention.

Preferred exemplary embodiments of the invention are illustrated in the drawings and will be described in more detail in the following description, whereby identical reference numerals refer to identical or similar or functionally identical components.

In each case schematically,
- Fig. 1: shows an exploded view of an inverter according to the invention;
- Fig. 2: shows a view of the inverter according to the invention from a longitudinal end facing away from the motor;
- Fig. 3: shows a view of the inverter according to the invention from a longitudinal end facing the motor;
- Fig. 4: shows a view of the inverter according to the invention at a transistor board comprising a contacting unit;
- Fig. 5: shows a view of the transistor board comprising the contacting unit of the inverter according to the invention;
- Fig. 6: shows an exploded view of the transistor board comprising the contacting unit of the inverter according to the invention;
- Figs. 7 and 8: show views of a contact plate and of a groove structure at the contact plate;
- Fig. 9: shows a sectional view of a motor according to the invention comprising the inverter according to the invention;
- Fig. 10: shows a view of the motor according to the invention from a side facing the inverter;
- Fig. 11: shows an exploded view of the transistor board and of the contacting unit of the inverter according to the invention and of a phase terminal of the motor according to the invention.

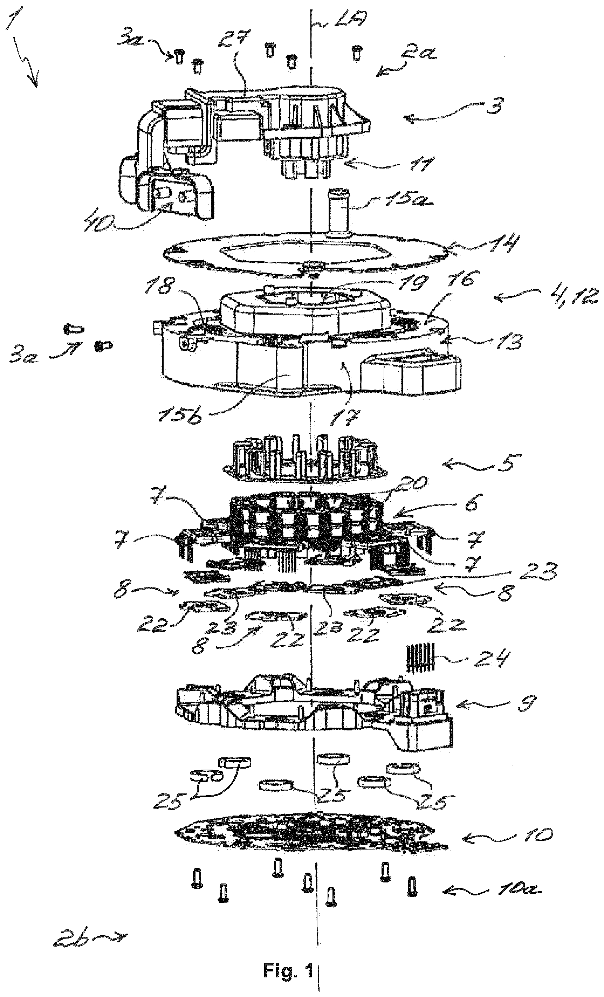

Fig. 1 shows an exploded view of an inverter 1 according to the invention. The inverter 1 thereby has a longitudinal direction LA. With respect to the longitudinal direction LA, a longitudinal end 2a facing away from the motor and a longitudinal end 2b facing the motor are specified in the inverter 1. The inverter 1 thereby has an EMI filter 3, a cooling element 4, a dielectric spacer 5, a capacitor board 6, six transistor boards 7, six contacting units 8, a dielectric carrier 9, and a control board 10.

The EMI filter 3 is electrically connected between the capacitor board 6 and direct current battery terminals 40 of the inverter. The EMI filter 3 thereby has an electric filter circuit of several capacitors, not shown here, and a choke 11. The capacitors and the choke 11 of the EMI filter 3 are received in an EMI housing 27 of the EMI filter 3. The EMI filter 3 is material bonded, preferably welded, to the capacitor board 6 via six bus bars of the choke 11, and is thus contacted in an electrically conductive manner. The EMI filter 3 is screwed to the cooling element 4 by means of a screw group 3a comprising several screws.

The cooling element 4 is pot-shaped and forms a housing 12 of the inverter. The cooling element 4 thereby receives the other components of the inverter 1 and surrounds them externally. The cooling element 4 thereby has a pot-shaped pot element 13, a cover plate 14, a separate inlet nozzle 15a, and an outlet nozzle 15b, which is integrated in the pot element 13. The pot element 13 is thereby produced of aluminum by means of a die casting process, and the cover plate 14 as well as the inlet nozzle 15a are material bonded, preferably soldered, to the pot element. The cooling element 4 thereby has a bottom 16 and a wall 17. The bottom 16 is thereby aligned transversely to the longitudinal direction LA, and the wall 17 is aligned parallel to the longitudinal direction LA, and surrounds the components of the inverter 1 transversely to the longitudinal direction LA. In addition, the cooling element 4 has a cooling duct 18, through which a cooling liquid can flow, and an assembly opening 19 for the EMI filter 3. The assembly opening 19 is thereby formed centrally in the bottom 16, and the cooling duct 18 is formed in the bottom 16 so as to surround the assembly opening 19. The cooling duct 18 is thereby formed to be open on one side in the pot element 13 and is fluidically closed externally by means of the cover plate 14.

The capacitor board 6 has several capacitors 20, which are arranged symmetrically in a circle on the capacitor board 6. The capacitors 20 are thereby material bonded, preferably welded, to the capacitor board 6, and are thus contacted in an electrically conductive manner.

The transistor boards 7 are aligned transversely to the longitudinal direction LA and are arranged so as to surround the capacitors 20 of the capacitor board 6. The transistor boards 7 are thereby arranged so as to be distributed evenly around the capacitors 20 of the capacitor board 6 in a circumferential direction, which surrounds the longitudinal direction LA. The transistor boards 7 are thereby material bonded, preferably welded, to the capacitor board 6 at contact points 21, and are thus contacted in an electrically conductive manner.

The spacer 5 is electrically insulating and is arranged in the housing 12 axially between the capacitor board 6 and the bottom 16 of the cooling element 4. The spacer 5 thereby receives the capacitors 20 of the capacitor board 6 and insulates them electrically from the cooling element 4. A curing heat-transferring casting compound can be arranged between the capacitors 20 and the cooling element 4.

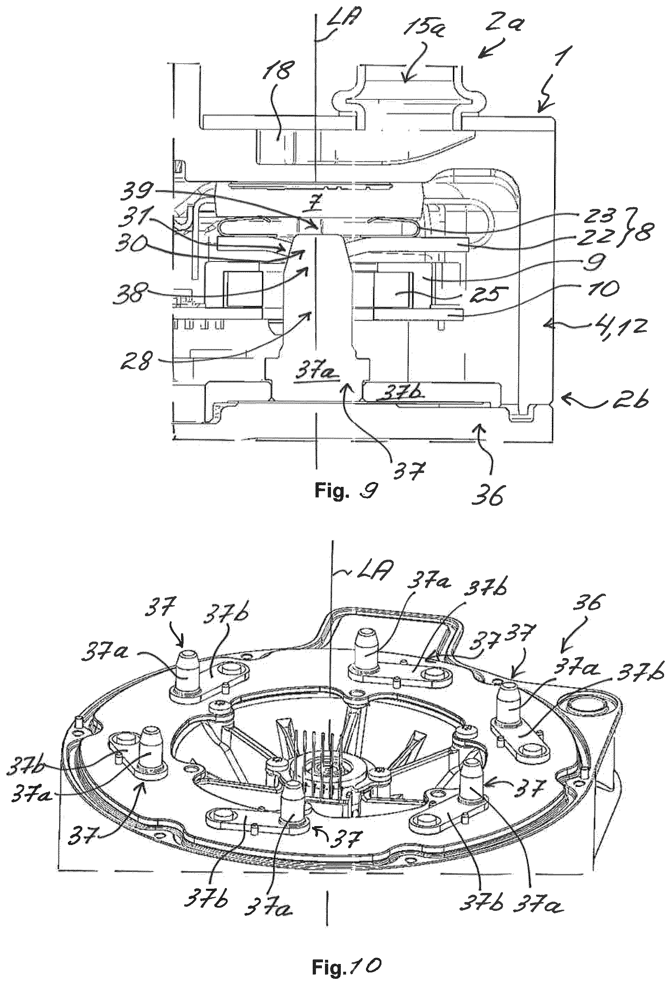

The contacting units 8 each have an electrically conductive contact plate 22 and a spring element 23. The respective contact plate 22 is thereby material bonded, preferably welded, to the respective transistor board 7, and is thus contacted in an electrically conductive manner. In addition, the contact plate 22 is material bonded, preferably welded, to the respective spring element 23. The contact plates 22 are provided for contacting with phase terminals of the motor, as will be described in more detail below on the basis of Figs. 9 - 11.

The carrier 9 is formed in a ring-shaped manner and is aligned transversely to the longitudinal direction LA. The carrier 9 carries the capacitor board 6 comprising the transistor boards 7. The contacting units 8 are thereby arranged between the carrier 9 and the transistor boards 7. The contact plates 22 are thereby arranged so as to face the carrier 9. The capacitor board 6 is screwed to the carrier 9 by means of a screw group comprising several screws, not shown here. In addition, contact elements 24 are received in the carrier 9. The carrier 9 is preferably formed of plastic.

The control board 10 is screwed to the carrier 9 by means of a screw group 10a comprising several screws. The control board 10 is thereby arranged at the carrier 9 facing away from the capacitor board 6. In other words, the carrier 9 is axially arranged between the control board 10 and the capacitor board 6. In addition, six ring-shaped cores 25 are arranged between the control board 10 and the carrier 9. If the inverter 1 is arranged at the motor, as will be described in more detail below on the basis of Figs. 9 - 11, the respective cores 25 are arranged around the respective phase terminals of the motor.

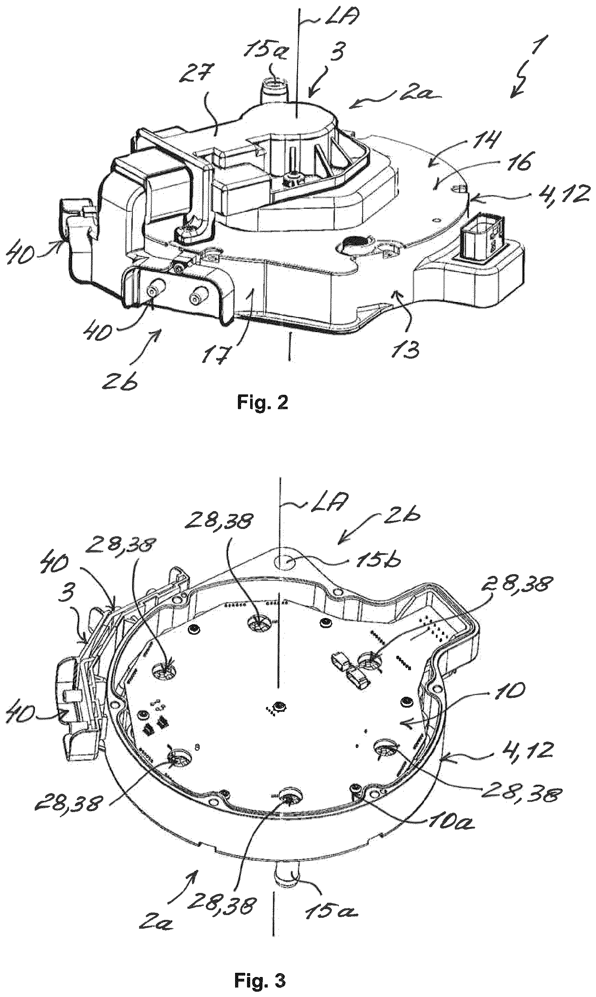

Fig. 2 shows a view of the inverter 1 according to the invention from the longitudinal end 2a facing away from the motor. The inverter 1 is already assembled here.

Fig. 3 shows a view of the inverter 1 according to the invention from the longitudinal end 2b facing the motor. In Fig. 3, openings 28 can be seen in the control board 10 and openings 38 can be seen in the carrier 9. Phase terminals of the motor are guided through the openings 28 and 38 to the respective contacting unit 8, as will be described in more detail below on the basis of Figs. 9 - 11.

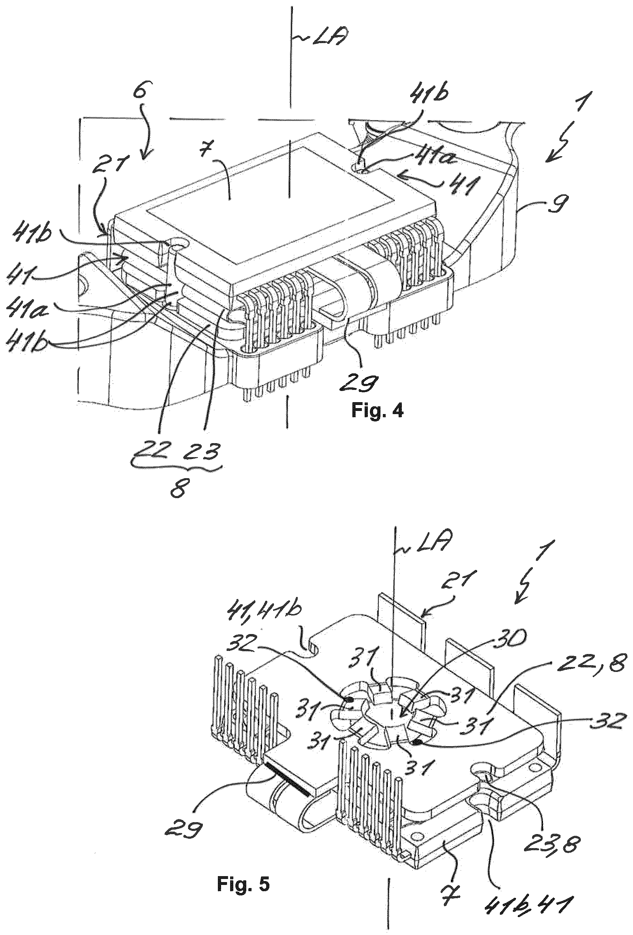

Fig. 4 shows a view of the inverter 1 according to the invention at the respective transistor board 7 comprising the respective assigned contacting unit 8. As already described above, the respective contacting unit 8 is arranged between the carrier 9 and the respective transistor board 7. The respective contact plate 22 is thereby arranged adjacent to the carrier 9, and the respective spring element 23 is arranged between the contact plate 22 and the transistor board 7. The respective transistor board 7 and the capacitor board 6 are thereby material bonded to one another, preferably welded, at the contact point 21, and are thus contacted in an electrically conductive manner.

As can be seen in Fig. 4, the inverter 1 contains positioning units 41 for each of the transistor boards 7. The respective positioning unit 41 contains two positioning projections 41a and six positioning openings 41b. The positioning projections 41a are formed on the carrier 9 and projects axially to the respective transistor board 7. Two of the positioning openings 41b are formed in the respective transistor board 7, two of the position openings 41b are formed in the respective contact plate 22, and two of the position openings 41b are formed in the respective spring element 23. The respective positioning projection 41a axially engages with the respective position opening 41b in the respective transistor board 7, with the respective position opening 41b in the respective contact plate 22, and with the respective position opening 41b in the respective spring element 23. The respective positioning unit 41 allows an axially compression of the assembly and prevents a side to side movement between the respective transistor plate 7, the respective contact plate 22, the respective spring element 23 and the carrier 9.

Fig. 5 shows a view of the transistor board 7 comprising the contacting unit 8 of the inverter 1 according to the invention. As can be seen particularly well in Fig. 5, the respective contact plate 22 has a central contact opening 30. **If** the inverter 1 is arranged at the electric motor, the respective phase terminal of the motor passes axially through the contact opening 30, as will be described in more detail below on the basis of Figs. 9 - 11. Six contact pins 31 are formed at the contact opening 30. The contact pins 31 are thereby directed towards the center of the contact opening and axially towards the spring element 23, and form a conical cone structure in the contact opening 30 for receiving the respective phase terminal of the motor. The cone structure can thereby axially increase the axial pressing force, which is generated by the phase terminal, in the direction of the respective transistor board 7.

The respective transistor board 7 and the respective contact plate 22 are thereby material bonded to one another, preferably welded, at a connecting point 29, and are thus contacted in an electrically conductive manner. The respective transistor board 7 and the respective contact plate 22 are thereby connected to one another on one side so as to allow relative movements between the transistor board 7 and the contact plate 22. The respective connecting point 29 is thereby arranged so as to be located opposite the respective contact point 21 between the transistor board 7 and the capacitor board 6. Fig. 5 additionally shows connecting points 32, at which the contact plate 22 is material bonded, preferably welded, to the spring element 23. The respective spring element 23 is thereby not firmly connected to the respective transistor board 7 and only rests against the transistor board 7. The connection between the contact plate 22 and the spring element 23 on the connecting points 32 simplify the assembly process.

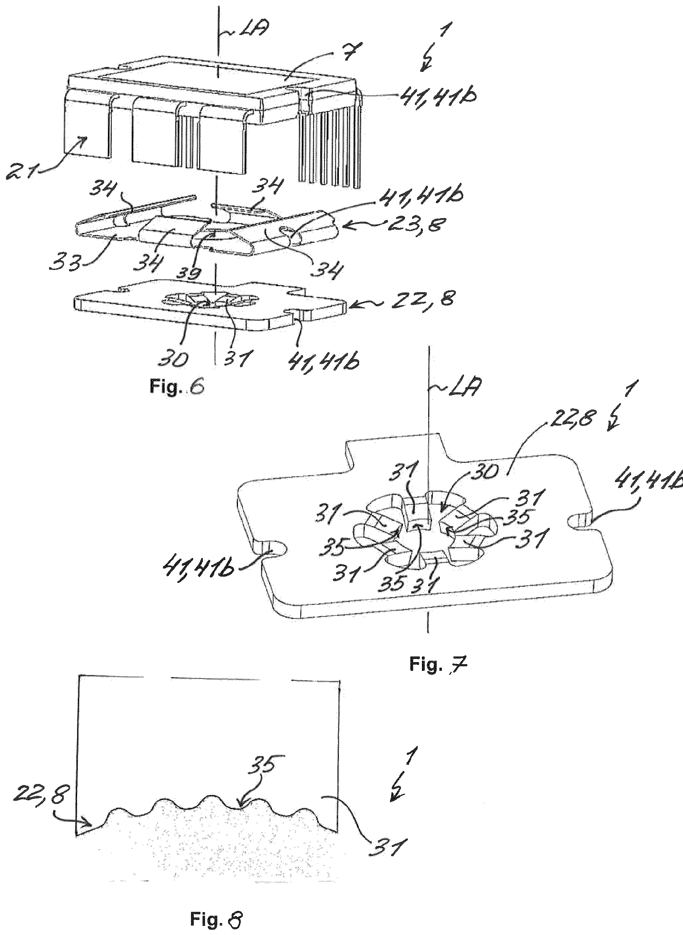

Fig. 6 shows an exploded view of the transistor board 7 comprising the contacting unit 8 of the inverter 1 according to the invention. It can be seen particularly well in Fig. 6 that the respective spring element 23 has a plate-like plate element 33 comprising four feet 34. The plate element 33 is thereby aligned transversely to the longitudinal direction LA and rests against the contact plate 22. The plate element 33 is material bonded, preferably welded, to the contact plate 22 at the connecting points 32, as shown in Fig. 5. The feet 34 radially adjoin the plate element 33 and are bent towards the center of the plate element 33. The feet 34 are thus resiliently arranged at the plate element 33. The respective plate element 33 rests with the feet 34 against the respective transistor board 7, so that the contact plate 22 and the respective transistor board 7 are resilient connected to one another via the feet 34 of the spring element 23. In addition, a passage opening 39, which axially corresponds to the contact opening 30 in the contact plate 22, is formed in the plate element 33. If the inverter 1 is arranged at the electric motor, the respective phase terminal of the motor passes axially through the contact opening 30 and the passage opening 39, as will be described in more detail below on the basis of Figs. 9 - 11.

Fig. 7 shows a view of the contact plate 22 of the contacting unit 8. In particular the contacting pins 31 can be seen in Fig. 8. At an axial contact surface facing the center of the contact opening 30, the respective contact pins 31 thereby have a groove structure 35.

Fig. 8 shows a view of the groove structure 35 at the respective contact pin 31 in the contact opening 30. The groove structure 35 is wave-shaped here. If the inverter 1 is arranged at the electric motor, the respective phase terminal of the motor passes axially through the contact opening 30, as will be described in more detail below on the basis of Figs. 9 - 11. An electrically conductive contact at several contact lines is thereby generated between the phase terminal and the groove structure 35.

Fig. 9 shows a sectional view of a motor 36 according to the invention comprising the inverter 1 according to the invention. Here, the inverter 1 is attached to the motor 36 with the longitudinal end 2b, which faces the motor. The inverter 1 and the motor 36 are firmly connected to one another in a detachable manner, preferably screwed to one another. The longitudinal direction LA of the inverter 1 is thereby aligned parallel to an axis of rotation of the motor 36 or of a rotor of the motor 36, respectively.

A phase terminal 37 of the motor 36 thereby has a connecting piece 37a, which is aligned in the longitudinal direction LA, and a fastening region 37b transversely to the longitudinal direction LA. The phase terminal 37 is thereby fastened to the motor 36 via the fastening region 37b.

The connecting piece 37a protrudes axially into the inverter 1 and passes through the opening 28 in the control board 10, through the opening 38 in the carrier 9, through the contact opening 30 in the contact plate 22, and through the passage opening 39 in the spring element 23. The connecting piece 37a of the respective phase terminal 37, the opening 28 in the control board 10, the opening 38 in the carrier 9, the contact opening 30 in the contact plate 22, and the passage opening 39 in the spring element 23 are therefore arranged coaxially to one another.

In the contact opening 30, the respective phase terminal 37 is in an electrically conductive contact with the contact pins 31 via the groove structure 35. The respective phase terminal 37 is thus contacted in an electrically conductive manner with the respective contact plate 22 and thus with the respective transistor board 7.

The respective phase terminal 37 or the connecting piece 37a, respectively, thereby generates an axial pressing force on the contact plate 22. The contact plate 22 thus presses the respective transistor board 7 via the spring element 23 against the cooling element 4 so as to transfer heat. The respective transistor board 7 can thus be cooled better. The conical cone structure of the contact pins 31 thereby axially increases the axial pressing force of the phase terminal 37 or of the connecting piece 37a, respectively, in the direction of the respective transistor board 7.

Fig. 10 shows a view of the motor 36 according to the invention from a side facing the inverter 1. It can be seen particularly well in Fig. 10 that the phase terminals 37 of the motor 36 extend axially to the inverter 1 with the connecting pieces 37a. According to the intended purpose, the phase terminals 37 of the motor 36 are formed to be electrically conductive.

The motor 36 shown here is a six-phase motor comprising exactly six phase terminals 37. The six phase terminals 37 are thereby arranged so as to be distributed around the axis of rotation of the motor 36 or of a rotor of the motor 36, respectively. As already described above, the inverter 1 therefore has exactly six transistor boards 7 for exactly six phase terminals 37 of the motor 36. Exactly six contacting units 8 for exactly six transistor boards 7 of the inverter 1 are therefore provided in the inverter 1.

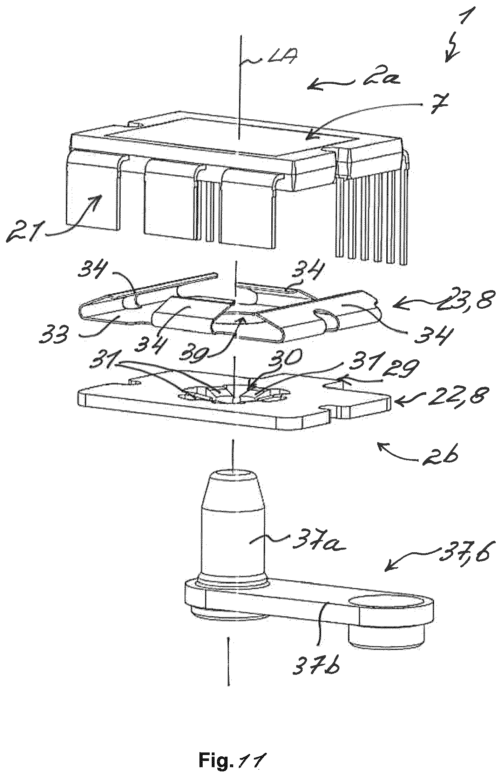

Fig. 11 now shows an exploded view of the transistor board 7 and of the contacting unit 8 of the inverter 1 according to the invention and of the phase terminal 37 of the motor 36 according to the invention. It can be seen particularly well here that the connecting piece 37a of the phase terminal 37 is aligned coaxially to the contact opening 30 and the passage opening 39.

## Claims

1. An inverter (1) for an electric motor (36),
- wherein the inverter (1) has a capacitor board (6) comprising at least one capacitor (20) and at least one transistor board (7),
- wherein the capacitor board (6) and the at least one transistor board (7) are aligned transversely to a longitudinal direction (LA) of the inverter (1),
- wherein the capacitor board (6) and the at least one transistor board (7) are electrically interconnected,
- wherein the inverter (1) has at least one electrically conductive contacting unit (8) for contacting at least one electrically conductive phase terminal (37) of the motor (36), and
- wherein the contacting unit (8) is connected to the at least one transistor board (7) in an electrically conductive manner,
**characterized in**
- **that** the at least one contacting unit (8) is resilient in response to an axial contact force in the longitudinal direction (LA),
- **that** the respective contacting unit (8) has a plate-like electrically conductive contact plate (22), which is aligned transversely to the longitudinal direction (LA), and a spring element (23), and
- **that** the respective spring element (23) is arranged axially between the respective contact plate (22) and the respective transistor board (7), and resiliently connects the respective transistor board (7) and the contact plate (22) to one another.

2. The inverter according to claim 1,
**characterized in**
- **that** the inverter (1) has a cooling element (4), which is aligned transversely to the longitudinal direction (LA) at least in some regions, and
- **that** in response to an axial pressing force, the respective contacting unit (8) presses the respective transistor board (7) against the cooling element (4) axially and so as to transfer heat.

3. The inverter according to claim 1 or 2,
**characterized in**
- **that** the respective spring element (23) is material bonded, preferably welded, to the respective contact plate (22), and/or
- **that** the respective contact plate (22) is connected in an electrically conductive manner and material bonded, preferably welded, to the respective transistor board (7), and/or
- **that** the respective transistor board (7) and the capacitor board (6) are material bonded to one another, preferably welded, at a contact point (21).

4. The inverter according to one of the preceding claims,
**characterized in**
- **that** the spring element (23) has a plate-like plate element (33), which is aligned transversely to the longitudinal direction (LA), and at least two feet (34), which integrally connect to the plate element (33), and
- **that** the respective spring element (23) rests with the plate element (33) against the contact plate (22) and resiliently with the feet (34) against the respectively transistor board (7).

5. The inverter according to one of the preceding claims,
**characterized in**
- **that** the respective contact plate (22) has a central contact opening (30) for inserting and for contacting the respective phase terminal (37) of the motor (36) in an electrically conductive manner, and
- **that** at least two contact pins (31), which are aligned towards the center of the contact opening (30) and axially to the spring element (23), are formed at the contact opening (30).

6. The inverter according to claim 5,
**characterized in**
**that** a preferably wave-shaped groove structure (35) is in each case formed at a contact surface of the respective contact pin (31), which is aligned parallel to the longitudinal direction (LA) and which faces towards the center of the contact opening (30).

7. An electric motor (36) comprising an inverter (1) according to one of the preceding claims,
- wherein the motor (36) has at least one electrically conductive phase terminal (37), which extends axially towards the inverter (1) at least in some regions,
- wherein the inverter (1) is axially attached to the motor (36) with a longitudinal end (2b), which faces the motor (36),
- wherein the contacting unit (8) of the inverter (1) is contacted in an electrically conductive manner with the phase terminal (37) of the motor (36).

8. The motor according to claim 7,
**characterized in**
- **that** the respective phase terminal (37) of the motor (36) generates an axial pressing force on the respective contacting unit (8) of the inverter (1), and
- **that** the respective contacting unit (8) presses the respective transistor board (7) against a cooling element (4) of the inverter (1) axially and so as to transfer heat by means of the axial pressing force of the phase terminal (37) of the motor (36).

9. The motor according to claim 7 or 8,
**characterized in**
- **that** the motor (36) is a six-phase motor comprising six phase terminals (37), and the six phase terminals (37) are arranged so as to be distributed around an axis of rotation of the motor (36), and
- the inverter (1) has six transistor boards (7) for the six phase terminals (37) of the motor (36), and the transistor boards (7) are arranged so as to be distributed around the at least one capacitor (20) of the capacitor board (6).

## Patentansprüche

1. Wechselrichter (1) für einen Elektromotor (36),
- wobei der Wechselrichter (1) eine Kondensatorplatine (6) aufweist, die mindestens einen Kondensator (20) und mindestens eine Transistorplatine (7) umfasst,
- wobei die Kondensatorplatine (6) und die mindestens eine Transistorplatine (7) quer zu einer Längsrichtung (LA) des Wechselrichters (1) ausgerichtet sind,
- wobei die Kondensatorplatine (6) und die mindestens eine Transistorplatine (7) miteinander elektrisch verbunden sind,
- wobei der Wechselrichter (1) mindestens eine elektrisch leitfähige Kontaktierungseinheit (8) zum Kontaktieren mindestens eines elektrisch leitfähigen Phasenanschlusses (37) des Motors (36) aufweist, und
- wobei die Kontaktierungseinheit (8) auf eine elektrisch leitfähige Weise mit der mindestens einen Transistorplatine (7) verbunden ist,
**dadurch gekennzeichnet**
- **dass** die mindestens eine Kontaktierungseinheit (8) gegenüber einer axialen Kontaktkraft in Längsrichtung (LA) elastisch ist,
- **dass** die jeweilige Kontaktierungseinheit (8) eine plattenförmige, elektrisch leitfähige Kontaktplatte (22), die quer zur Längsrichtung (LA) ausgerichtet ist, und ein Federelement (23) aufweist, und
- **dass** das jeweilige Federelement (23) axial zwischen der jeweiligen Kontaktplatte (22) und der jeweiligen Transistorplatine (7) angeordnet ist und die jeweilige Transistorplatine (7) und die Kontaktplatte (22) elastisch miteinander verbindet.

2. Wechselrichter nach Anspruch 1,
**dadurch gekennzeichnet**
- **dass** der Wechselrichter (1) ein Kühlelement (4) aufweist, das mindestens in einigen Bereichen quer zur Längsrichtung (LA) ausgerichtet ist, und
- **dass** die jeweilige Kontaktierungseinheit (8) als Reaktion auf eine axiale Druckkraft die jeweilige Transistorplatine (7) axial gegen das Kühlelement (4) drückt, um Wärme zu übertragen.

3. Wechselrichter nach Anspruch 1 oder 2,
**dadurch gekennzeichnet**
- **dass** das jeweilige Federelement (23) mit der jeweiligen Kontaktplatte (22) stoffschlüssig verbunden, vorzugsweise geschweißt, ist und/oder
- **dass** die jeweilige Kontaktplatte (22) mit der jeweiligen Transistorplatine (7) auf elektrisch leitfähige Weise und stoffschlüssig verbunden, vorzugsweise geschweißt, ist und/oder
- **dass** die jeweilige Transistorplatine (7) und die Kondensatorplatine (6) an einem Kontaktpunkt (21) miteinander stoffschlüssig verbunden, vorzugsweise geschweißt, sind.

4. Wechselrichter nach einem der vorhergehenden Ansprüche,
**dadurch gekennzeichnet**
- **dass** das Federelement (23) ein plattenartiges Plattenelement (33), das quer zur Längsrichtung (LA) ausgerichtet ist, und mindestens zwei Füße (34), die einstückig mit dem Plattenelement (33) verbunden sind, aufweist und
- **dass** das jeweilige Federelement (23) mit dem Plattenelement (33) an der Kontaktplatte (22) und mit den Füßen (34) elastisch an der jeweiligen Transistorplatine (7) anliegt.

5. Wechselrichter nach einem der vorhergehenden Ansprüche,
**dadurch gekennzeichnet**
- **dass** die jeweilige Kontaktplatte (22) eine zentrale Kontaktöffnung (30) zum Einführen und zum Kontaktieren des jeweiligen Phasenanschlusses (37) des Motors (36) auf elektrisch leitfähige Weise aufweist und
- **dass** an der Kontaktöffnung (30) mindestens zwei Kontaktstifte (31) ausgebildet sind, die auf die Mitte der Kontaktöffnung (30) und axial auf das Federelement (23) ausgerichtet sind.

6. Wechselrichter nach Anspruch 5,
**dadurch gekennzeichnet**
**dass** an einer Kontaktfläche des jeweiligen Kontaktstifts (31) in jedem Fall eine vorzugsweise wellenförmige Rillenstruktur (35) ausgebildet ist, die parallel zur Längsrichtung (LA) ausgerichtet ist und die der Mitte der Kontaktöffnung (30) zugewandt ist.

7. Elektromotor (36), der einen Wechselrichter (1) nach einem der vorstehenden Ansprüche umfasst,
- wobei der Motor (36) mindestens einen elektrisch leitfähigen Phasenanschluss (37) aufweist, der sich mindestens in einigen Bereichen axial in Richtung des Wechselrichters (1) erstreckt,
- wobei der Wechselrichter (1) mit einem Längsende (2b), das dem Motor (36) zugewandt ist, axial am Motor (36) befestigt ist,
- wobei die Kontaktierungseinheit (8) des Wechselrichters (1) auf eine elektrisch leitfähige Weise mit dem Phasenanschluss (37) des Motors (36) in Kontakt steht.

8. Motor nach Anspruch 7,
**dadurch gekennzeichnet**
- **dass** der jeweilige Phasenanschluss (37) des Motors (36) eine axiale Andruckkraft auf die jeweilige Kontaktierungseinheit (8) des Wechselrichters (1) ausübt, und
- **dass** die jeweilige Kontaktierungseinheit (8) die jeweilige Transistorplatine (7) axial gegen ein Kühlelement (4) des Wechselrichters (1) drückt, um Wärme mittels der axialen Andruckkraft des Phasenanschlusses (37) des Motors (36) zu übertragen.

9. Motor nach Anspruch 7 oder 8,
**dadurch gekennzeichnet**
- **dass** der Motor (36) ein Sechsphasenmotor ist, der sechs Phasenanschlüsse (37) umfasst, und die sechs Phasenanschlüsse (37) so angeordnet sind, dass sie um eine Drehachse des Motors (36) verteilt sind, und
- der Wechselrichter (1) sechs Transistorplatinen (7) für die sechs Phasenanschlüsse (37) des Motors (36) aufweist und die Transistorplatinen (7) so angeordnet sind, dass sie um den mindestens einen Kondensator (20) der Kondensatorplatine (6) verteilt sind.

## Revendications

1. Onduleur (1) pour un moteur électrique (36),
- dans lequel l'onduleur (1) comporte une carte de condensateur (6) comprenant au moins un condensateur (20) et au moins une carte de transistor (7),
- dans lequel la carte de condensateur (6) et la au moins une carte de transistor (7) sont alignées transversalement à une direction longitudinale (LA) de l'onduleur (1),
- dans lequel la carte de condensateur (6) et la au moins une carte de transistor (7) sont raccordées électriquement,
- dans lequel l'onduleur (1) comporte au moins une unité de contact électroconductrice (8) destinée à être en contact avec au moins une borne de phase électroconductrice (37) du moteur (36), et
- dans lequel l'unité de contact (8) est raccordée à la au moins une carte de transistor (7) d'une manière électroconductrice,
**caractérisé en ce que**
- la au moins une unité de contact (8) est résiliente en réponse à une force de contact axiale dans la direction longitudinale (LA),
- l'unité de contact (8) respective comporte une plaque de contact électroconductrice tabulaire (22), qui est alignée transversalement à la direction longitudinale (LA), et un élément ressort (23), et
- l'élément ressort (23) respectif est agencé axialement entre la plaque de contact (22) respective et la carte de transistor (7) respective, et relie de manière résiliente la carte de transistor (7) respective et la plaque de contact (22) l'une à l'autre.

2. Onduleur selon la revendication 1,
**caractérisé en ce que**
- l'onduleur (1) comporte un élément de refroidissement (4), qui est aligné transversalement à la direction longitudinale (LA) au moins dans certaines régions, et
- en réponse à une force de pression axiale, l'unité de contact (8) respective appuie la carte de transistor (7) respective contre l'élément de refroidissement (4) axialement et de manière à transférer de la chaleur.

3. Onduleur selon la revendication 1 ou 2,
**caractérisé en ce que**
- l'élément ressort (23) respectif est assemblé par liaison par matière, de préférence soudé, à la plaque de contact (22) respective, et/ou
- la plaque de contact (22) respective est raccordée d'une manière électroconductrice et assemblée par liaison par matière, de préférence soudée, à la carte de transistor (7) respective, et/ou
- la carte de transistor (7) respective et la carte de condensateur (6) sont assemblées l'une à l'autre par liaison par matière, de préférence soudées, en un point de contact (21).

4. Onduleur selon l'une quelconque des revendications précédentes,
**caractérisé en ce que**
- l'élément ressort (23) comporte un élément plaque tabulaire (33), qui est aligné transversalement à la direction longitudinale (LA), et au moins deux pattes (34), qui sont reliés d'un seul tenant à l'élément plaque (33), et
- l'élément ressort (23) respectif repose avec l'élément plaque (33) contre la plaque de contact (22) et d'une manière résiliente avec les pattes (34) contre la carte de transistor (7) respective.

5. Onduleur selon l'une quelconque des revendications précédentes,
**caractérisé en ce que**
- la plaque de contact (22) respective comporte une ouverture de contact centrale (30) conçue pour insérer, et entrer en contact avec, la borne de phase (37) respective du moteur (36) d'une manière électroconductrice, et
- au moins deux broches de contact (31), qui sont alignées vers le centre de l'ouverture de contact (30) et axialement par rapport à l'élément ressort (23), sont formées au niveau de l'ouverture de contact (30).

6. Onduleur selon la revendication 5,
**caractérisé en ce que**
une structure en rainure de préférence de forme ondulée (35) est à chaque fois formée au niveau d'une surface de contact de la broche de contact (31) respective, qui est alignée parallèlement à la direction longitudinale (LA) et qui est orientée vers le centre de l'ouverture de contact (30).

7. Moteur électrique (36) comprenant un onduleur (1) selon l'une quelconque des revendications précédentes,
- dans lequel le moteur (36) présente au moins une borne de phase électroconductrice (37), qui s'étend axialement vers l'onduleur (1) au moins dans certaines régions,
- dans lequel l'onduleur (1) est fixé axialement au moteur (36) avec une extrémité longitudinale (2b), qui est orientée vers le moteur (36),
- dans lequel l'unité de contact (8) de l'onduleur (1) est mise en contact d'une manière électroconductrice avec la borne de phase (37) du moteur (36).

8. Moteur selon la revendication 7,
**caractérisé en ce que**
- la borne de phase (37) respective du moteur (36) génère une force de pression axiale sur l'unité de contact (8) respective de l'onduleur (1), et
- l'unité de contact (8) respective appuie la carte de transistor (7) respective contre un élément de refroidissement (4) de l'onduleur (1) axialement et de manière à transférer de la chaleur au moyen de la force de pression axiale de la borne de phase (37) du moteur (36).

9. Moteur selon la revendication 7 ou 8,
**caractérisé en ce que**
- le moteur (36) est un moteur à six phases comprenant six bornes de phase (37), et les six bornes de phase (37) sont agencées de manière à être réparties autour d'un axe de rotation du moteur (36), et
- l'onduleur (1) possède six cartes de transistors (7) destinées aux six bornes de phase (37) du moteur (36), et les cartes de transistors (7) sont agencées de manière à être réparties autour du au moins un condensateur (20) de la carte de condensateur (6).
